# EUROPÄISCHE PATENTSCHRIFT

(11) **EP 0 417 133 B1**
(45) Veröffentlichungstag und Bekanntmachung des Hinweises auf die Patenterteilung: **20.10.1993**
(21) Anmeldenummer: 89905645.1
(22) Anmeldetag: 20.05.1989
(51) Int. Cl.: G01R 33/46

(54) **NMR-SPEKTROMETER MIT EINEM PROBENWECHSLER**
NMR-SPECTROMETER WITH SAMPLE EXCHANGER
SPECTROMETRE RMN AVEC CHANGEUR D'ECHANTILLONS

(30) Priorität: 27.05.1988 DE 3818039
(43) Veröffentlichungstag der Anmeldung: 20.03.1991
(73) Patentinhaber: Bruker Analytische Messtechnik GmbH, 76287 Rheinstetten (DE)
(72) Erfinder: DUPREE, Raymond, Coventry CV4 7AL (GB)
(74) Vertreter: KOHLER SCHMID + PARTNER
(86) Internationale Anmeldenummer: DE8900324
(87) Internationale Veröffentlichungsnummer: WO8911646

(56) Entgegenhaltungen:
- EP-A- 0 188 368
- EP-A- 0 308 654
- US-A- 4 091 323
- US-A- 4 581 583
- Patent Abstracts of Japan, vol. 11, No. 260 (P-608)(2707), 22 August 1987; & JP, A, 6263846

## Beschreibung

Die Erfindung betrifft ein NMR-Spektrometer mit einer Magnetanordnung, die ein Magnetfeld erzeugt, das in einem vorgegebenen Bereich möglichst homogen ist, mit einer im homogenen Bereich des Magnetfeldes angeordneten Probenaufnahme und mit einem Probenwechsler, der ein Probenmagazin und Einrichtungen zum Überführen jeweils einer Probe von dem Magazin zur Probenaufnahme und zurück aufweist.

NMR-Spektrometer sind in vielen Ausführungsformen bekannt. Manche von ihnen sind mit Probenwechslern versehen, die einen automatischen Betrieb rund um die Uhr gestatten, wie beispielsweise die NMR-Spektrometer der AM-Serie der Anmelderin. Solche Probenwechsler erlauben zwar die automatische Aufnahme von Spektren in schneller Folge, jedoch ist die Zeit, die für die Aufnahme eines Spektrums benötigt wird, in hohem Maße von der Spin-Gitter-Relaxationszeit T₁ abhängig, weil diese Relaxationszeit die Zeitdauer bestimmt, während der eine Probe vorpolarisiert werden muß, bevor sie zur Aufnahme des Spektrums angeregt werden kann. Die zur Vorpolarisation benötigte Zeit beträgt typischerweise 5xT₁. Daher erfordern Messungen an Proben mit langen Spin-Gitter-Relaxationszeiten T₁ außerordentlich viel Zeit, insbesondere wenn diese Relaxationszeiten im Bereich von Stunden liegen. Insbesondere bei Festkörperproben ist einerseits T₁ sehr groß, andererseits aber die Spin-Spin-Relaxationszeit T₂ relativ klein, so daß die Vorpolarisation nicht in einem zweiten Magneten mit anschließender Überführung der Probe in das Magnetfeld des Spektrometers erfolgen kann, weil bei dem Transfer die Probe durch Bereiche mit wechselnder und kleiner Magnetfeldstärke (Erdfeld) gebracht werden müßte und dadurch die Vorpolarisation der Probe wieder zerstört werden würde (siehe z.B. R. Dupree und M. E. Smith, J. Magn. Res. 75, 153 (1987) sowie C. A. Fyfe, Solid State NMR for Chemists, C.F.C. Press Ontario, Kanada, 1983).

MNR-Spectrometer mit einem Probenwechsler und mit einem Probenmagazin sind beispielsweise auch aus der US-A-4 581 583 bekannt.

Durch die EP-A-0 188 368 ist ein NMR-Spectrometer bekannt, bei dem im homogenen Bereich des Magnetfelds ein stillstehendes Gehäuse angeordnet ist, in dem im Abstand voneinander und parallel zueinander Rotoren angeordnet sind, in denen jeweils eine Probe angeordnet ist. Es kann jeder Probe eine eigene Beobachtungsspule zugeordnet sein, oder die beiden Proben befinden sich innerhalb einer einzigen Beobachtungsspule. Die Rotoren sind somit die Probenaufnahme, und ein Magazin, aus dem die Proben in die Probenaufnahme und von der Probenaufnahme zurück transportiert wird, ist nicht vorgesehen. Die Messung der verschiedenen Proben erfolgt bei Verwendung einer einzigen HF-Spule zwangsläufig gleichzeitig, bei Verwendung mehrerer HF-Spulen ist ebenfalls eine gleichzeitige Messung vorgesehen. Die Druckschrift offenbart nicht eine Möglichkeit, die Probe sehr lange Zeit und ohne die Probe zu messen im Magnetfeld vorzupolarisieren, um sie erst anschließend an den eigentlichen Meßort zu bringen, wo sich die HF-Spule befindet und das Magnetfeld ausreichend homogen ist.

Der Erfindung liegt die Aufgabe zugrunde, eine Möglichkeit zu finden, mit einem Spektrometer der eingangs genannten Art Messungen an Proben mit langen Spin-Gitter-Relaxationszeiten T₁ in zeitlichen Abständen auszufuhren, die klein sind im Verhältnis zur Spin-Gitter-Relaxationszeit T₁.

Diese Aufgabe wird nach der Erfindung dadurch gelöst, daß das Probenmagazin innerhalb des von der Magnetanordnung erzeugten Magnetfeldes angeordnet ist.

Die Anordnung eines Probenmagazines innerhalb des von der Magnetanordnung erzeugten Magnetfeldes ermöglicht es, eine größere Anzahl von Proben zur Vorpolarisierung dem gleichen Magnetfeld auszusetzen, in dem dann auch die Messung stattfindet, so daß jeweils die zum Messen der sich im Magazin befindenden Proben benötigte Zeit zur Vorpolarisierung der jeweils als letztes in das Magazin eingebrachten Probe zur Verfügung steht. Auf diese Weise läßt sich die Arbeitsleistung eines NMR-Spektrometers gemäß der Anzahl der Proben vervielfachen, die sich in dem Magazin befinden, das innerhalb des von der Magnetanordnung erzeugten Magnetfeldes angeordnet ist.

Das Probenmagazin kann in einer Weise ausgebildet sein, wie es von den bisherigen Probenwechslern her bekannt ist. Besonders vorteilhaft ist jedoch die Ausbildung als drehbare Trommel, die zu ihrer Drehachse parallele Aufnahmen für eine Anzahl Proben aufweist, die ihrerseits durch Drehen der Trommel nacheinander mit der Einrichtung zum Überführen der Proben in Eingriff bringbar ist. Die Anwendung einer solchen drehbaren Trommel hat den besonderen Vorteil, daß eine Trommel auf sehr engem Raum, wie er in dem vom Magneten erzeugten Magnetfeld nur vorhanden ist, eine relativ große Anzahl von Proben aufnehmen kann. Besonders vorteilhaft ist die Anwendung einer Trommel, wenn das NMR-Spektrometer einen Kryomagneten aufweist, weil sich eine solche Trommel in der Bohrung des Kryomagneten im Abstand von dem Bereich extremer Homogenität besonders gut anordnen und ggf. sogar in einen die Probenaufnahme enthaltenden Probenkopf eines solchen Spektrometers integrieren läßt.

Die Einrichtung zum Überführen der Proben kann auch Mittel zum Überführen der Proben von einem äußeren Magazin in das innerhalb des Magnetfeldes angeordnete innere Magazin umfassen, so daß auch hier ein vollautomatischer Betrieb über größere Zeiten hinaus möglich ist. Dabei können zum Wechseln von Proben zwischen dem inneren und dem äußeren Magazin übliche Greiferanordnungen Verwendung finden, während besonders die Einrichtung zum Überführen der Probe von dem inneren Magazin zur Probenaufnahme pneumatische Leitungen umfassen kann, in denen die Probe von einem Luftstrom getragen wird und durch Steuern des Luftstromes zum Überführen von dem Probenkopf zum Magazin und umgekehrt wahlweise anhebbar oder absenkbar ist. Solche pneumatischen Einrichtungen können aber auch dazu dienen, die Proben von einer Übergabestelle aus, zu der sie von einem äußeren Magazin durch mechanische Mittel gebracht werden, in das innere Magazin zu transportieren und umgekehrt.

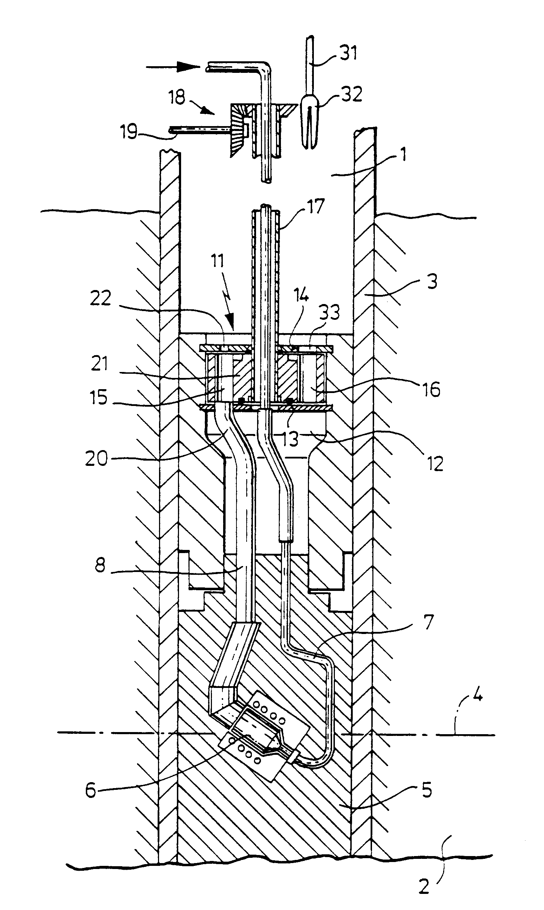

Weitere Einzelheiten und Ausgestaltungen der Erfindung ergeben sich aus der folgenden Beschreibung des in der Zeichnung dargestellten Ausführungsbeispiels. Die Zeichnung zeigt einen schematischen Längsschnitt durch die Magnetanordnung eines nach der Erfindung ausgebildeten NMR-Spektrometers.

In der bei dem dargestellten Ausführungsbeispiel vertikalen Bohrung 1 eines nur schematisch angedeuteten Kryomagneten 2 befindet sich ein Shimsystem 3, das so ausgelegt ist, daß das vom Kryomagneten erzeugte Magnetfeld innerhalb eines Bereiches der Bohrung 1, der sich symmetrisch zu beiden Seiten einer zur Bohrung 1 senkrechten Ebene 4 erstreckt, eine hohe Homogenität aufweist. In die Bohrung 1 des Kryomagneten ist ein ebenfalls nur schematisch angedeuteter Probenkopf 5 eingesetzt, der in dem sich beidseitig zur Ebene 4 erstreckenden, extrem homogenen Bereich des Magnetfeldes eine Aufnahme 6 für eine zu untersuchende Probe aufweist. Diese Aufnahme 6 ist zur Achse der Bohrung 1 unter dem sogenannten "magischen Winkel" angeordnet und kann um ihre Achse mittels einer kleinen Luftturbine in schnelle Rotation versetzt werden. Außerdem enthält der Probenkopf in nicht näher dargestellter Weise die zur Aufnahme von NMR-Spektren erforderlichen Sende- und Empfangsspulen, ggf. Einrichtungen zur Temperierung der Probe u.dgl. Weiterhin enthält der Probenkopf 5 eine an das untere Ende der Probenaufnahme 6 angeschlossene Luftleitung 7 und eine an das obere Ende der Probenaufnahme 6 angeschlossene Probenleitung 8. Diese Leitungen bieten die Möglichkeit, mittels eines über die Luftleitung 7 zugeführten Luftstromes eine Probe aus der Probenaufnahme 6 durch die Probenleitung 8 auszutragen oder aber eine in die Probenleitung 8 eingesetzte Probe bei entsprechend vermindertem Luftstrom bis in die Probenaufnahme 6 abzusenken. Insoweit hat das Spektrometer mit dem Kryomagneten 1, dem Shimsystem 3 und dem Probenkopf 5 eine übliche Ausbildung, so daß sich nähere Erläuterungen hierzu erübrigen.
Weitere Einzelheiten über den Aufbau solcher Spektrometer können insbesondere den Prospekten der Anmelderin über die von ihr hergestellten und vertriebenen NMR-Spektrometer der Typen CXP und MSL entnommen werden.

Bei dem dargestellten Ausführungsbeispiel ist in der Bohrung 1 des Kryomagneten 2 axial oberhalb des Probenkopfes 5 ein Probenmagazin 11 angeordnet, das eine zentrale Bohrung 12 aufweist, in der zwischen zwei zur Achse des Kryomagneten 1 senkrechten Platten 13, 14 eine drehbare Trommel 21 angeordnet ist, die an ihrem Umfang eine Anzahl achsparalleler Bohrungen aufweist, von denen in der Zeichnung nur zwei Bohrungen 15, 16 sichtbar sind. Jede Bohrung ist dazu ausgebildet, eine Probe, beispielsweise in Form eines die zu untersuchende Substanz enthaltenden Röhrchens, aufzunehmen. Die Trommel 21 ist auf einer Hohlwelle 17 befestigt, die aus dem Kryomagneten 2 oben hinausragt und an ihrem oberen Ende mit einem Antrieb 18 versehen ist. Bei dem nur schematisch dargestellten Ausführungsbeispiel umfaßt der Antrieb 18 ein Kegelrad-Paar und eine weitere Welle 19, die beispielsweise zu einem Stellmotor führen kann. Es wäre aber auch ein einfacher Handgriff denkbar, der das Drehen der Trommel 21 von Hand ermöglichte, die dann mit einer Rasteinrichtung versehen sein könnte, welche dazu geeignet ist, die Trommel 21 in unterschiedlichen Stellungen zu fixieren. In jedem Fall ist die Trommel in eine der Anzahl ihrer Bohrungen gleiche Anzahl Stellungen bringbar, in denen jeweils eine der Bohrungen dem Ende 20 der Probenleitung 8 gegenübersteht, die sich im Probenkopf 5 befindet. An einer Stelle, die dem Ende 20 der Probenleitung 8 gegenüberliegt, weist die obere Platte 14 eine kleine Bohrung 22 auf, die das Entweichen von Luft zuläßt.

Die dargestellte Anordnung bietet die Möglichkeit, durch Drehen der Trommel 21 eine beliebige der in den Bohrungen 15, 16 enthaltenen Proben in eine Position zu bringen, in der sich die Probe vor dem Ende 20 der Probenleitung 8 befindet. Durch Bemessen des Lufstromes, der über die Luftleitung 7 zugeführt wird, kann dann die Probe aus der entsprechenden Kammer 15 der Trommel 21 in die Aufnahme 6 des Probenkopfes 5 abgesenkt und dort untersucht werden. Nach Abschluß der Aufnahme eines Spektrums kann dann die Probe durch Erhöhen des Luftstromes wieder in die Kammer 15 der Trommel 21 angehoben werden. Danach kann durch Drehen der Trommel eine andere der in der Trommel enthaltenen Proben ausgewählt und nach Absenken in die Probenaufnahme 6 untersucht werden. Auf diese Weise ist es insbesondere möglich, die innerhalb der Trommel 21 enthaltenen Proben in beliebiger Reihenfolge nacheinander zu untersuchen, wobei der gesamte Vorgang automatisiert werden kann.

Um die Trommel 21 mit Proben zu beschicken, wäre es grundsätzlich möglich, das Probenmagazin 11 so auszubilden, daß es nach oben aus der Bohrung 1 des Kryomagneten herausnehmbar ist. Statt dessen wäre es auch möglich, das innere Magazin in den nach unten aus der Bohrung herausnehmbaren Probenkopf 5 zu integrieren. Von besonderem Vorteil ist die Anwendung von Einrichtungen, die ein automatisches Beschicken des inneren Magazins ermöglichen. So könnte ein pneumatisches System vorgesehen werden, das dem pneumatischen System zum Einbringen der Probe von der Trommel 21 in den Probenraum 6 des Probenkopfes 5 ähnlich ist, ggf. in Kombination mit einem automatischen Probenwechsler, der dem automatischen Probenwechsler der oben erwähnten NMR-Spektrometer vom Typ AM ähnlich ist. Ein solcher Probenwechsler könnte beispielsweise eine vertikal verschiebbare Stange 31 aufeisen, die an ihrem Ende mit einer Greifzange 32 versehen ist und die in die Bohrung 1 des Kryomagneten 2 bis zur Trommel 21 abgesenkt werden kann, um eine Probe in die Trommel einzusetzen bzw. der Trommel wieder zu entnehmen. Demgemäß ist die Stange 31 mit dem Greifer 32 koaxial zu einer Bohrung 16 der Trommel angeordnet und es weist die obere Platte 14 an der Stelle, an welcher die Stange 31 mit der Trommel 21 in Eingriff kommen soll, eine entsprechende Aussparung 33 auf. Es könnte aber auch an die Aussparung 33 eine Luftleitung eines entsprechenden pneumatischen Systems anschließen, die sich bis zum Ende der Bohrung des Kryomagneten erstreckt und an welche die Probe von dem Greifer übergeben wird.

Bei der erfindungsgemäßen Anordnung bildet die Trommel 21 ein Magazin, in dem eine Anzahl Proben in einem Bereich des Magnetfeldes des Kryomagneten 2 längere Zeit gehalten werden kann, in dem das Magnetfeld zwar nicht die zur Aufnahme eines zur NMR-Spektrums erforderliche, extrem hohe Homogenität, aber doch noch annähernd die gleiche Stärke aufweist wie das Magnetfeld in dem homogenen Bereich, so dar hier eine Vormagnetisierung der Proben stattfinden kann, während andere Proben einer Messung unterworfen werden. Auf diese Weise ist es also möglich, Proben mit großer Spin-Gitter-Relaxationszeit T₁ zu magnetisieren, ohne daß dadurch das Spektrometer für die Durchführung von Messungen blockiert ist. Dabei könnte beispielsweise so vorgegangen werden, daß das Magazin mit Proben mit großem T₁ gefüllt wird und während der zur Vormagnetisieren benötigten Zeit Messungen an anderen Proben ausgeführt werden. Es kann aber auch ein fortlaufender Betrieb mit Messungen an Proben mit hoher Relaxationszeit ausgführt werden, indem nacheinander die jeweils gemessene Probe der Trommel entnommen und durch eine neue ersetzt wird, so daß jeweils die Gesamtzeit, die zur Aufnahme der Spektren von den übrigen Proben benötigt wird, zur Magnetisierung der jeweils als letztes eingeführten Probe zur Verfügung steht. Auch ist bei akkumulierenden Messungen eine zyklische Wiederholung der Messungen an den einzelnen Proben möglich, so daß die Relaxationszeiten, die zwischen den einzelnen Messungen abgewartet werden können, für die Messung anderer Proben ausgenutzt werden können.

Es versteht sich, daß die Erfindung nicht auf das nur schematisch dargestellte Ausführungsbeispiel beschränkt ist, das lediglich das Prinzip der Erfindung veranschaulichen soll. Es kommt vielmehr für die Erfindung weder darauf an, wie das Probenmagazin im einzelnen ausgebildet ist noch in welcher Weise es beschickt und entleert werden kann, einschließlich der Art der Überführung der Probe von dem Magazin zur Probenaufnahme und zurück. Für die Erfindung ist es lediglich von Bedeutung, daß innerhalb des von der Magnetanordnung erzeugten Magnetfeldes ein Probenmagazin angeordnet ist, das es gestattet, eine Anzahl von Proben innerhalb des Magnetfeldes aufzubewahren und nach einer ausreichenden Vormagnetisierungszeit in den Meßkopf einzuführen, ohne daß die Probe das Magnetfeld verläßt oder auch nur einem die Vormagnetisierung störenden Wechsel des Magnetfeldes ausgesetzt wird. Es versteht sich, daß dem Fachmann viele Möglichkeiten zur Verfügung stehen, dieses Prinzip zu verwirklichen, und insbesondere der Ablauf des Probenwechsels und der im einzelnen durchzuführenden Messungen in vielfältiger Weise automatisiert und programmiert werden kann.

## Patentansprüche

1. NMR-Spektrometer mit einer Magnetanordnung (2), die ein Magnetfeld erzeugt, das in einem vorgegebenen Bereich möglichst homogen ist, mit einer im homogenen Bereich des Magnetfeldes angeordneten Probenaufnahme (6) und mit einem Probenwechsler, der ein Probenmagazin (11) und Einrichtungen zum Überführen jeweils einer Probe von dem Magazin zur Probenaufnahme und zurück aufweist, dadurch gekennzeichnet, daß ein Raum innerhalb des von der Magnetanordnung (2) erzeugten Magnetfeldes vorgesehen ist, in dem das Probenmagazin (11) angeordnet ist, wobei das Magnetfeld in diesem Raum annähernd die gleiche Stärke aufweist wie das Magnetfeld in dem homogenen Bereich.

2. NMR-Spektrometer nach Anspruch 1, dadurch gekennzeichnet, daß das Probenmagazin als drehbare Trommel (21) ausgebildet ist, die zu ihrer Drehachse parallele Aufnahmen (15, 16) für eine Anzahl Proben aufweist, die ihrerseits durch Drehen der Trommel (21) nacheinander mit der Einrichtung (7, 8, 20) zum Überführen der Proben in Eingriff bringbar ist.

3. NMR-Spektrometer nach Anspruch 1 oder 2, dadurch gekennzeichnet, daß das Spektrometer einen Kryomagneten aufweist und daß der Raum als Bohrung (1) in dem Kryomagneten (2) ausgebildet ist, in der das Probenmagazin (11) im Abstand von dem homogenen Magnetfeldbereich angeordnet ist.

4. NMR-Spektrometer nach einem der vorhergehenden Ansprüche, dadurch gekennzeichnet, daß die Einrichtung zum Überführen der Proben Mittel (31, 32) zum Überführen der Proben von einem äußeren Magazin in das innerhalb des Magnetfeldes angeordnete Probenmagazin (11) umfaßt.

5. NMR-Spektrometer nach einem der vorhergehenden Ansprüche, dadurch gekennzeichnet, daß die Einrichtung zum Überführen der Probe pneumatische Leitungen (7, 8, 20) umfaßt, in denen die Probe von einem Luftstrom getragen wird und durch Steuern des Luftstromes zum Überführen von der Probenaufnahme (6) zum Probenmagazin (11) und umgekehrt wahlweise anhebbar bzw. absenkbar ist.

## Claims

1. NMR spectrometer with a magnet configuration (2) which produces a magnetic field which is very homogeneous in a predetermined region, with a sample receptacle (6) arranged in the homogeneous region of the magnetic field and with a sample changer which exhibits a sample cartridge (11) and devices for transferring one sample at a time from the cartridge to the sample receptacle and back, characterised in that a region within the magnetic field produced by the magnet configuration (2) is provided for in which the sample cartridge (11) is arranged, whereby the magnetic field in this region exhibits approximately the same strength as the magnetic field in the homogeneous region.

2. NMR spectrometer according to claim 1, characterised in that the sample cartridge is configured as a rotatable drum (21) which exhibits receptacles (15, 16), parallel to its axis of rotation, for a plurality of samples which for their part, by means of turning the drum (21), can be brought sequentially in engagement with the device (7, 8, 20) for transfer of the samples.

3. NMR spectrometer according to claim 1 or 2, characterized in that the spectrometer exhibits a cryomagnet and in that the region is configured as a bore (1) in the cryomagnet (2) in which the sample cartridge (11) is arranged at a distance from the homogeneous magnetic field region.

4. NMR spectrometer according to one of the previous claims, characterised in that the device for transfer of the samples includes means (31, 32) for transfer of the samples from an outer cartridge into the sample cartridge (11) located within the magnetic field.

5. NMR spectrometer according to one of the previous claims, characterised in that the device for transfer of the sample comprises pneumatic conduits (7, 8, 20) in which the sample is carried by an air stream and, by controlling the air stream, can be selectively lifted and lowered for transfer from the sample receptacle (6) to the sample cartridge (11) and back, respectively.

## Revendications

1. Spectromètre RMN comportant un dispositif magnétique (2) produisant un champ magnétique aussi homogène que possible dans une zone prédéterminée, un compartiment d'échantillons (6) disposé dans la zone homogène du champ magnétique et un changeur d'échantillons comprenant un chargeur d'échantillons (11) et des dispositifs de transfert d'un échantillon à la fois du chargeur au compartiment d'échantillons et vice versa, caractérisé en ce qu'un espace est prévu à l'intérieur du champ magnétique produit par le dispositif magnétique (2) et dans lequel est disposé le chargeur d'échantillons (11), le champ magnétique dans cet espace ayant approximativement la même intensité que le champ magnétique dans la zone homogène.

2. Spectromètre RMN selon la revendication 1, caractérisé en ce que le chargeur d'échantillons se présente sous la forme d'un tambour rotatif (21) présentant des compartiments (15, 16) parallèles à son axe de rotation et destinés à un certain nombre d'échantillons et qui peuvent à leur tour être successivement mis en prise avec le dispositif (7, 8, 20) de transfert des échantillons, par rotation du tambour (21).

3. Spectromètre RMN selon la revendication 1 ou 2, caractérisé en ce que le spectromètre présente un cryoaimant et que l'espace se présente sous la forme d'un creux (1) à l'intérieur du cryoaimant (2) et dans lequel est disposé le chargeur d'échantillons (11) à distance de la zone homogène de champ magnétique.

4. Spectromètre RMN selon l'une des revendications précédentes, caractérisé en ce que le dispositif de transfert des échantillons comprend des moyens (31, 32) de transfert des échantillons d'un chargeur externe au chargeur d'échantillons (11) disposé à l'intérieur du champ magnétique.

5. Spectromètre RMN selon l'une des revendications précédentes, caractérisé en ce que le dispositif comprend pour le transfert de l'échantillon des conduits pneumatiques (7, 8, 20) dans lesquels l'échantillon est porté par un courant d'air et peut être facultativement relevé ou abaissé par commande du courant d'air en vue de son transfert du compartiment d'échantillons (6) au chargeur d'échantillons (11) et vice versa.
